(19) Europäisches Patentamt
European Patent Office
Office européen des brevets

(11) **EP 4 409 307 B1**

(12) **EUROPÄISCHE PATENTSCHRIFT**

(45) Veröffentlichungstag und Bekanntmachung des Hinweises auf die Patenterteilung:
**10.09.2025  Patentblatt 2025/37**

(21) Anmeldenummer: **22755161.1**

(22) Anmeldetag: **25.07.2022**

(51) Internationale Patentklassifikation (IPC):
**G01R 31/34** *(2020.01)*    **G01R 19/00** *(2006.01)*
**G01R 31/28** *(2006.01)*    **G01R 25/00** *(2006.01)*
**G01R 35/00** *(2006.01)*

(52) Gemeinsame Patentklassifikation (CPC):
**G01R 31/343;** G01R 19/0092; G01R 31/2829;
G01R 35/00

(86) Internationale Anmeldenummer:
**PCT/EP2022/070777**

(87) Internationale Veröffentlichungsnummer:
**WO 2023/046334 (30.03.2023 Gazette 2023/13)**

(54) **VERFAHREN UND DETEKTORVORRICHTUNG ZUR ÜBERWACHUNG VON STROMSENSOREN SOWIE ELEKTRISCHES ANTRIEBSSYSTEM**

METHOD AND DETECTOR DEVICE FOR MONITORING CURRENT SENSORS, AND ELECTRIC DRIVE SYSTEM

PROCÉDÉ ET DISPOSITIF DE DÉTECTION POUR LA SURVEILLANCE DE CAPTEURS DE COURANT, ET SYSTÈME D'ENTRAÎNEMENT ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.09.2021  DE 102021210718**

(43) Veröffentlichungstag der Anmeldung:
**07.08.2024  Patentblatt 2024/32**

(73) Patentinhaber: **Robert Bosch GmbH**
**70442 Stuttgart (DE)**

(72) Erfinder: **PAULUS, Sebastian**
**73728 Esslingen Am Neckar (DE)**

(56) Entgegenhaltungen:
**DE-A1- 102004 040 051    DE-A1- 102018 251 746**

• **HARKE M C ET AL: "The Spatial Effect and Compensation ofCurrent Sensor Differential Gains for Three-Phase Three-Wire Systems", IEEE TRANSACTIONS ON INDUSTRY APPLICATIONS, IEEE SERVICE CENTER, PISCATAWAY, NJ, US, vol. 44, no. 4, 1 July 2008 (2008-07-01), pages 1181 - 1189, XP011231802, ISSN: 0093-9994, DOI: 10.1109/TIA.2008.926208**

## Beschreibung

### Technisches Gebiet

Die vorliegende Erfindung betrifft ein Verfahren und eine Detektorvorrichtung zur Überwachung von Stromsensoren, insbesondere Stromsensoren für Phasenströme in einem mehrphasigen elektrischen Antriebssystem. Die vorliegende Erfindung betrifft ferner ein elektrisches Antriebssystem mit einer solchen Vorrichtung zur Überwachung von Stromsensoren.

### Stand der Technik

Elektrische Antriebssysteme finden in zahlreichen Anwendungsgebieten Einsatz. Dabei kann elektrische Energie von einer elektrischen Energiequelle, wie zum Beispiel einer Batterie oder Ähnlichem, bereitgestellt werden. Die bereitgestellte elektrische Energie kann mittels eines Stromrichters in eine ein- oder mehrphasige elektrische Spannung konvertiert werden, welche an den Anschlüssen einer elektrischen Maschine bereitgestellt wird, um einen vorbestimmten Betriebszustand einzustellen. Zur Regelung des elektrischen Antriebssystems und zum Einstellen vorgegebener Sollwertvorgaben an der elektrischen Maschine können beispielsweise die elektrischen Ströme von dem Stromrichter zu den Phasenanschlüssen der elektrischen Maschine erfasst werden. Hierzu kann für jede Phase der elektrischen Maschine ein Stromsensor vorgesehen sein, welcher ein zu dem elektrischen Strom korrespondierendes analoges oder digitales Signal bereitstellt.

Die Druckschrift DE 10 2011 003 566 A1 beschreibt ein Verfahren und eine Vorrichtung zum Kalibrieren eines Stromsensors, insbesondere eines Stromsensors zur Erfassung eines Phasenstroms einer durch einen Wechselrichter gesteuerten elektrischen Maschine. Hierzu wird vorgeschlagen, einen erfassten Istwert oder eine aus einem erfassten Istwert abgeleitete Größe mit einem vorgegebenen Sollwert zu vergleichen und eine Abweichung von einem Normzustand zu bestimmen. Die Druckschrift DE 10 2018 251746 A1 offenbart ein Verfahren zum Ermitteln eines Verstärkungsfehlers einer Strommesseinrichtung einer Sensoreinheit einer elektrischen Maschine, wobei die Maschine eine Statorwicklung mit zumindest drei Phasen und einen Rotor aufweist, der um eine Rotationsachse drehbar gelagert ist. Durch das Verfahren wird der Einfluss eines Rotorwinkels des Rotors auf das Ermitteln des Verstärkungsfehlers mittels eines Tiefpassfilters ausgeschlossen.

### Offenbarung der Erfindung

Die vorliegende Erfindung schafft ein Verfahren und eine Vorrichtung zur Überwachung von Stromsensoren sowie ein elektrisches Antriebssystem mit den Merkmalen der unabhängigen Patentansprüche. Weitere Vorteilhafte Ausführungsformen sind Gegenstand der abhängigen Patentansprüche.

Demgemäß ist vorgesehen:
Ein Verfahren zur Überwachung von Stromsensoren, insbesondere zur Überwachung von Stromsensoren für Phasenströme in einem mehrphasigen elektrischen Antriebssystem. Das Verfahren umfasst einen Schritt zum Erfassen von Sensorwerten für die Phasenströme. Insbesondere kann jeweils ein Stromsensor einen Phasenstrom des mehrphasigen elektrischen Antriebssystems ermitteln und einen zu dem ermittelten Phasenstrom korrespondierenden Sensorwert bereitstellen. Das Verfahren umfasst ferner einen Schritt zum Berechnen einer Stromsumme unter Verwendung der erfassten Sensorwerte von den Stromsensoren. Weiterhin umfasst das Verfahren einen Schritt zum Bestimmen eines Realteils sowie eines Imaginärteils einer komplexen Stromsumme. Hierbei kann der Realteil und der Imaginärteil der komplexen Stromsumme unter Verwendung eines Rotorwinkels der elektrischen Maschine in dem elektrischen Antriebssystem bestimmt werden. Weiterhin umfasst das Verfahren einen Schritt zum Berechnen eines komplexen Verstärkungsfehlers der Stromsensoren. Der komplexe Verstärkungsfehler wird aus einem Quotienten des Realteils der komplexen Stromsumme und einer aktuellen effektiven Phasenstrom-Amplitude, sowie einem Quotienten des Imaginärteils der komplexen Stromsumme und der aktuellen effektiven Phasenstrom-Amplitude berechnet. Schließlich umfasst das Verfahren einen Schritt zum Berechnen eines Betrags des komplexen Verstärkungsfehlers.

Weiterhin ist vorgesehen:
Eine Detektorvorrichtung zur Überwachung von Stromsensoren, insbesondere zur Überwachung von Stromsensoren für Phasenströme in einem mehrphasigen elektrischen Antriebssystem. Die Detektorvorrichtung umfasst eine Eingangsschnittstelle und eine Recheneinrichtung. Die Eingangsschnittstelle ist dazu ausgelegt, Sensorwerte von Stromsensoren zu erfassen, wobei jeweils ein Stromsensor einen Phasenstrom des mehrphasigen elektrischen Antriebssystems ermittelt und einen zu dem ermittelten Phasenstrom korrespondierenden Sensorwert bereitstellt. Insbesondere können Sensorwerte von Stromsensoren an den Phasenanschlüssen einer elektrischen Maschine des elektrischen Antriebssystems erfasst werden. Alternativ ist auch eine Erfassung der Phasenströme an einer anderen Stelle möglich. Die Recheneinrichtung ist dazu ausgelegt, eine Stromsumme unter Verwendung der erfassten Sensorwerte von den Stromsensoren zu berechnen. Weiterhin ist die Recheneinrichtung dazu ausgelegt, einen Realteil und einen Imaginärteil einer komplexen Stromsumme zu berechnen. Der Realteil und der Imaginärteil können unter Verwendung eines Rotorwinkels der elektrischen Maschine in dem elektrischen Antriebssystem berechnet werden. Ferner ist die Recheneinrichtung dazu ausgelegt, einen komplexen Verstärkungsfehler zu berechnen. Der komplexe Verstärkungsfehler wird aus einem Quotienten des Realteils der komplexen Stromsumme und einer aktuellen effektiven Phasenstrom-Amplitude sowie einem Quotienten des Imaginärteils der komplexen Stromsumme und der aktuellen effektiven Phasenstrom-Amplitude berechnet. Schließlich ist die Recheneinrichtung dazu ausgelegt, einen Betrag des komplexen Verstärkungsfehlers zu berechnen.

Schließlich ist vorgesehen:
Ein elektrisches Antriebssystem mit einer mehrphasigen elektrischen Maschine, mehreren Stromsensoren und einer erfindungsgemäßen Detektorvorrichtung. Die Stromsensoren sind jeweils dazu ausgelegt, einen elektrischen Phasenstrom zu erfassen und einen zu dem erfassten Phasenstrom korrespondierenden Sensorwert auszugeben.

Vorteile der Erfindung

Der vorliegenden Erfindung liegt die Erkenntnis zugrunde, dass für eine strombasierte Regelung eines elektrischen Antriebssystems hohe Anforderungen an die Genauigkeit und Zuverlässigkeit der Stromsensoren gestellt werden, welche die elektrischen Ströme in dem Antriebssystem erfassen. Hierzu ist es erforderlich, die von den Stromsensoren bereitgestellten Sensordaten zu überprüfen und zu plausibilisieren, um Fehlfunktionen, wie beispielsweise einen Verstärkungsfehler (Strom-Sensor-Gain-Fehler) zu erkennen.

Es ist daher eine Idee der vorliegenden Erfindung, dieser Erkenntnis Rechnung zu tragen und eine Diagnose von Stromsensoren in einem elektrischen Antriebssystem vorzusehen, welche auch bei dynamischen Vorgängen sowie asymmetrischen Widerständen in den verschiedenen Phasen des elektrischen Antriebssystems eine zuverlässige und rasche Diagnose der Stromsensoren ermöglicht.

Hierzu ist es vorgesehen, die Messwerte der Stromsensoren für die einzelnen Phasen der elektrischen Maschine zunächst zu summieren und hieraus eine Stromsumme zu bilden. Die Stromsensoren können beispielsweise innerhalb des Stromrichters, an den Phasenanschlüssen der elektrischen Maschine oder entlang der Zuleitungen zwischen dem Stromrichter und der elektrischen Maschine vorgesehen sein. Die Stromsensoren können hierbei ein analoges oder digitales Signal ausgeben, welches zu dem jeweils erfassten elektrischen Strom korrespondiert. Das von den Stromsensoren ausgegebene Signal kann somit einem Wert entsprechen, welcher beispielsweise proportional zu dem elektrischen Strom in der jeweiligen Phasenleitung ist. Auf diese Weise können die Stromsensoren jeweils einen Sensorwert bereitstellen, der einem Phasenstrom des mehrphasigen elektrischen Antriebssystems entspricht.

Bei fehlerfreien Stromsensoren und einer fehlerfreien elektrischen Maschine ist diese Stromsumme in der Regel Null. Im Fehlerfall, beispielsweise bei unterschiedlichen Verstärkungsfaktoren in den einzelnen Stromsensoren, kann sich jedoch eine von Null abweichende Stromsumme ergeben. In konventionellen Systemen können die Stromsensoren beispielsweise durch Betrachtung der Minima und der Maxima in den Phasenströmen über mehrere elektrische Perioden detektiert werden. Solche Verfahren funktionieren jedoch in der Regel nur im eingeschwungenen Zustand. Variiert der Strom dagegen innerhalb einer elektrischen Umdrehung zu stark, so sind die Minima und Maxima der Phasenströme unterschiedlich. Infolgedessen ist für solche Betriebszustände mittels konventioneller Verfahren keine zuverlässige Diagnose möglich. Darüber hinaus kann es selbst im eingeschwungenen Zustand aufgrund unterschiedlicher elektrischer Widerstände in den verschiedenen Phasen, beispielsweise im Wechselrichter, in der elektrischen Maschine oder den Zuleitungen, zu unterschiedlichen Werten für die Minima und Maxima kommen.

Die vorliegende Erfindung sieht daher ein Verfahren vor, welches den genannten Nachteilen konventioneller Verfahren Rechnung trägt und auch bei dynamischen Betriebsbedingungen eine zuverlässige Diagnose des Stromverstärkungsfaktors der Stromsensoren ermöglicht.

Die vorliegende Erfindung betrachtet hierzu die oben beschriebene Stromsumme, das heißt die Summe aller elektrischen Ströme in den einzelnen Phasen einer elektrischen Maschine. Aus dieser Summe wird unter Verwendung eines gemessenen oder berechneten Rotorwinkels eine komplexe Stromsumme gebildet, das heißt die berechnete Stromsumme wird in einen Realteil und in einen Imaginärteil zerlegt. Realteil und Imaginärteil der komplexen Stromsumme können daraufhin gegebenenfalls getrennt voneinander gefiltert werden. Hierzu ist beispielsweise eine Tiefpassfilterung, eine kombinierte Tiefpass- und Bandpassfilterung oder gegebenenfalls auch eine Mittelwertbildung möglich. Der aktuelle Effektivstrom, der beispielsweise aus einer dq-Transformation gewonnen werden kann, wird dabei mit der gleichen Filterzeitkonstante gefiltert, wie sie für die Filterung des Real- und Imaginärteils der komplexen Stromsumme verwendet wird. Für die Filterung der Stromsumme, insbesondere auch eine getrennte Filterung des Realteils und des Imaginärteils ist bevorzugt die Betrachtung der entsprechenden zeitlichen Verläufe erforderlich. Entsprechend sind hierbei unter den Begriffen Stromsumme, Realteil oder Imaginärteil bevorzugt jeweils zeitliche Verläufe der entsprechenden Größen zu verstehen.

Im Weiteren kann ein komplexer Verstärkungsfehler aus komplexer Stromsumme und aktueller Phasenstrom-Amplitude berechnet werden. Hierbei ergibt sich der Realteil des komplexen Verstärkungsfehlers aus dem Quotienten des Realteils der komplexen Stromsumme und der aktuellen Phasenstrom-Amplitude, und der Imaginärteil des komplexen Verstärkungsfehlers ergibt sich aus dem Quotienten des Imaginärteils der komplexen Stromsumme und der Phasenstrom-Amplitude.

Schließlich kann der Betrag des komplexen Verstärkungsfehlers berechnet werden. Dieser Wert der Amplitude kann beispielsweise mit einem Schwellwert verglichen werden, um zu überprüfen, ob sich der Verstärkungsfehler noch innerhalb eines vorgegebenen Toleranzbereiches befindet oder nicht.

Auf diese Weise kann auch bei einer dynamischen Änderung der Phasenströme die Stromsensorverstärkung der Stromsensoren für die Erfassung der Phasenströme zuverlässig plausibilisiert werden.

Gemäß einer Ausführungsform umfasst das Verfahren einen Schritt zum Vergleichen des berechneten Betrags, das heißt der Amplitude, des komplexen Verstärkungsfehlers mit einem vorbestimmten Schwellwert. Ferner kann das Verfahren einen Schritt zum Detektieren eines Sensorfehlers umfassen, Hierbei kann ein Sensorfehler detektiert werden, falls der berechnete Betrag des komplexen Verstärkungsfehlers den vorbestimmten Schwellwert überschreitet. Der vorgegebene Schwellwert kann so gewählt werden, dass Abweichungen der Stromsensorverstärkung innerhalb eines vorgegebenen Toleranzbereiches akzeptiert werden, während Abweichungen der Stromsensorverstärkung außerhalb des vorgegebenen Toleranzbereiches als fehlerhaft klassifiziert werden. Wird auf diese Weise eine Stromsensorverstärkung detektiert, welche außerhalb des akzeptablen Toleranzbereiches liegt, das heißt größer ist als der vorgegebene Schwellwert, so können daraufhin gegebenenfalls geeignete Maßnahmen ergriffen werden. Beispielsweise können die Sensorwerte der Stromsensoren in einem solchen Fall als unzuverlässig klassifiziert werden und gegebenenfalls nicht weiter für die Regelung des elektrischen Antriebssystems herangezogen werden. Falls erforderlich, kann das elektrische Antriebssystem in einem solchen Fall in einen Notlaufbetrieb überführt werden oder gegebenenfalls auch vollständig abgeschaltet werden. Selbstverständlich sind je nach Anwendungsbereich auch beliebige andere geeignete Maßnahmen möglich.

Gemäß einer Ausführungsform umfasst das Verfahren zur Überwachung der Stromsensoren einen Schritt zum Filtern der berechneten Stromsumme. Hierbei kann es sich um eine Tiefpassfilterung, eine kombinierten Tiefpass- und Bandpassfilterung oder gegebenenfalls auch um eine Mittelwertbildung handeln. Entsprechend kann der Realteil der komplexen Stromsumme und der Imaginärteil der komplexen Stromsumme unter Verwendung der zuvor gefilterten Stromsumme berechnet werden.

Gemäß einer Ausführungsform umfasst das Verfahren Schritte zum Filtern des Realteils der komplexen Stromsumme und des Imaginärteils der komplexen Stromsumme. Weiterhin umfasst das Verfahren Schritte zum Bestimmen eines effektiven Phasenstroms, sowie zum Filtern des zeitlichen Verlaufs des effektiven Phasenstroms. Insbesondere werden bei einer solchen Filterung sowohl der Realteil und der Imaginärteil der komplexen Stromsumme als auch der Verlauf des effektiven Phasenstroms mit einer gleichen Zeitkonstante gefiltert. Somit kann das Berechnen des komplexen Verstärkungsfehlers unter Verwendung des gefilterten Realteils und des gefilterten Imaginärteil der komplexen Stromsumme sowie des gefilterten effektiven Phasenstroms berechnet werden. Auch hierbei kann das Filtern sowohl eine Tiefpassfilterung, eine kombinierte Tiefpass- und Bandpassfilterung oder eine Mittelwertbildung umfassen.

Alternativ ist es auch möglich, eine Filterung nach der Berechnung der komplexen Phasenstrom-Amplituden auszuführen.

Die Erfindung wird durch die beigefügten Ansprüche definiert.

Kurze Beschreibung der Zeichnungen

Weitere Merkmale und Vorteile der Erfindung werden nachfolgend anhand der Figuren erläutert. Dabei zeigen:

Fig. 1: eine schematische Darstellung eines elektrischen Antriebssystems mit einer Detektorvorrichtung gemäß einer Ausführungsform; und

Fig. 2: ein Ablaufdiagramm, wie es einem Verfahren zur Überwachung von Stromsensoren gemäß einer Ausführungsform zugrunde liegt.

Beschreibung von Ausführungsformen

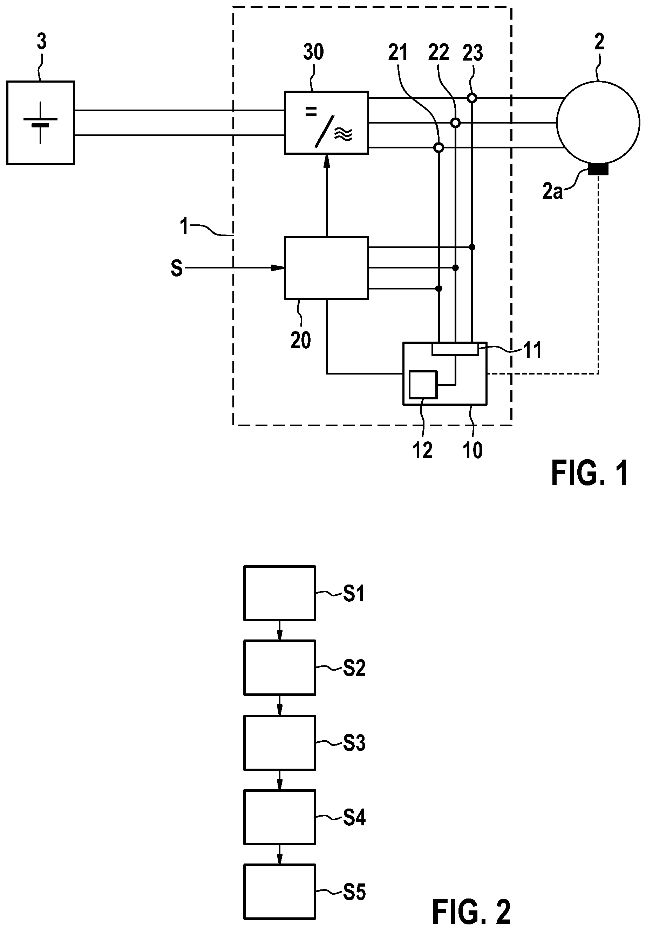

Figur 1 zeigt eine schematische Darstellung eines Blockschaubilds eines elektrischen Antriebssystems gemäß einer Ausführungsform. Das elektrische Antriebssystem umfasst in dem hier dargestellten Beispiel eine elektrische Energiequelle 3, beispielsweise eine Gleichspannungsquelle, einen Stromrichter 1 und eine elektrische Maschine 2. In dem hier dargestellten Beispiel handelt es sich bei dem Stromrichter 1 um einen Wechselrichter, der gemäß einer Sollwertvorgabe S aus der durch die elektrische Energiequelle 3 bereitgestellten Gleichspannung eine mehrphasige Wechselspannung generiert und diese an den Phasenanschlüssen der elektrischen Maschine 2 bereitstellt. Obwohl es sich bei dem hier dargestellten Beispiel um eine dreiphasige elektrische Maschine 2 handelt, ist die vorliegende Erfindung grundsätzlich auch auf beliebige mehrphasige elektrische Maschinen anwendbar, die auch eine von Drei abweichende Anzahl von Phasenanschlüssen aufweisen können.

Grundsätzlich ist die vorliegende Erfindung auch auf beliebige Wicklungsanordnungen innerhalb der elektrischen Maschine 2 anwendbar, beispielsweise Stern- oder Dreieckschaltungen. Wesentlich ist hierbei lediglich, dass die elektrische Maschine 2 eine Wicklungsanordnung aufweist, bei welcher der gesamte elektrische Strom über die Phasenanschlüsse fließt, und kein zusätzlicher Stromfluss, beispielsweise über einen zweiten Sternpunkt oder Ähnliches vorgesehen ist.

Der Stromrichter 1 kann beispielsweise eine Leistungselektronik mit mehreren Schaltelementen aufweisen. Die Schaltelemente dieser Leistungselektronik 30 können beispielsweise mittels Steuersignalen von einer Steuereinrichtung 20 angesteuert werden. Auf diese Weise kann, beispielsweise durch eine pulsbreitenmodulierte Ansteuerung, aus der von der elektrischen Energiequelle 3 bereitgestellten Gleichspannung eine mehrphasige Wechselspannung erzeugt werden, um die elektrische Maschine 2 basierend auf einer Sollwertvorgabe S anzusteuern. Bei der Sollwertvorgabe S kann es sich beispielsweise um ein einzustellendes Drehmoment oder Ähnliches handeln.

Zur Ansteuerung der elektrischen Maschine 2 gemäß der Sollwertvorgabe S kann die Steuereinrichtung 20 die elektrischen Ströme in den Phasenleitungen zwischen dem Stromrichter 1 und der elektrischen Maschine 2 erfassen und die Ansteuerung der Leistungselektronik 3 gemäß den erfassten elektrischen Strömen und der Sollwertvorgabe S anpassen. Hierzu können die elektrischen Ströme mittels entsprechender Stromsensoren 21 bis 23 erfasst werden. Die Stromsensoren 21 bis 23 können beispielsweise innerhalb des Stromrichters 1, an den Phasenanschlüssen der elektrischen Maschine 2 oder entlang der Zuleitungen zwischen dem Stromrichter 1 und der elektrischen Maschine 2 vorgesehen sein. Die Stromsensoren 21 bis 23 können hierbei ein analoges oder digitales Signal ausgeben, welches zu dem jeweils erfassten elektrischen Strom korrespondiert. Das von den Stromsensoren 21 bis 23 ausgegebene Signal kann somit einem Wert entsprechen, welcher beispielsweise proportional zu dem elektrischen Strom in der jeweiligen Phasenleitung ist.

Für eine korrekte Regelung des elektrischen Antriebssystems ist es dabei erforderlich, dass der Regelung korrekte Messwerte der elektrischen Phasenströme zugrunde gelegt werden. Hierzu können die von den Stromsensoren 21 bis 23 ausgegebenen Sensorsignale mittels einer Detektorvorrichtung 10 überprüft und plausibilisiert werden. Nachfolgend wird ein erfindungsgemäßes Verfahren zur Überprüfung der Sensorwerte von den Sensoren 21 bis 23 beschrieben.

Zunächst werden die von den Stromsensoren 21 bis 23 bereitgestellten Sensorsignale an einer Eingangsschnittstelle 11 der Detektorvorrichtung 10 erfasst. Da, wie oben bereits beschrieben, der elektrische Strom zwischen dem Stromrichter 1 und der elektrischen Maschine 2 ausschließlich über die Phasenleitungen fließt, welche von den Stromsensoren 21 bis 23 überwacht werden, ist die Summe der von den Sensoren 21 bis 23 erfassten Ströme im fehlerfreien Zustand stets Null. Die Recheneinrichtung 12 der Detektorvorrichtung 10 berechnet daher aus den von den Stromsensoren 21 bis 23 bereitgestellten Sensorwerten zunächst einen Summenstrom I_sum, indem die zu den Sensorwerten korrespondierenden reellen Werte der jeweiligen Phasenströme aufsummiert werden. Hierbei kann es aufgrund verschiedener Faktoren zu einem von Null abweichenden Summenstrom kommen. Beispielsweise können die einzelnen Stromsensoren 21 bis 23 unterschiedliche, zumindest leicht abweichende Stromsensorverstärkungen aufweisen.

Falls der Summenstrom Null ergibt oder unterhalb eines vorgegebenen Grenzwertes liegt, so kann dies als ein Indiz auf korrekt arbeitende Stromsensoren 21 bis 23 gewertet werden. Andernfalls, das heißt falls der Summenstrom von Null abweicht bzw. einen vorgegebenen Grenzwert überschreitet, so kann das nachfolgend beschriebene Diagnoseschema angewendet werden, um eine Fehlfunktion in den Stromsensoren 21 bis 23, insbesondere abweichende Sensorstromverstärkungen zu diagnostizieren. Alternativ kann das nachfolgend beschriebene Diagnoseschema auch dauerhaft aktiv sein.

Gegebenenfalls kann der auf Grundlage der von den Stromsensoren 21 bis 23 bereitgestellten Sensorwerte ermittelte Summenstrom I_sum gefiltert werden. Hierzu ist beispielsweise eine Tiefpassfilterung, eine kombinierte Tiefpass- und Bandpassfilterung oder eine Mittelwertbildung möglich. Durch eine solche Filterung kann ein gefilterter Summenstrom I_f_sum ermittelt werden. Wird eine solche Filterung auf den Summenstrom angewendet, so kann auch der gefilterte Summenstrom I_f_sum daraufhin überprüft werden, ob er von Null abweicht bzw. einen vorgegebenen Grenzwert überschreitet.

Falls der Summenstrom I_sum bzw. der gefilterte Summenstrom I_f_sum von Null abweicht oder den vorgegebenen Grenzwert überschreitet, so wird aus dem ermittelten Summenstrom I_sum zunächst eine komplexe Stromsumme erzeugt. Dabei ergibt sich der Realteil I_Re sowie der Imaginärteil I_Im der komplexen Stromsumme zu:

$$I\_Re = (I\_sum - I\_f\_sum) * \sin(phi) * 2$$

$$I\_Im = (I\_sum - I\_f\_sum) * \cos(phi) * 2$$

wobei hierbei phi der Rotorwinkel der elektrischen Maschine 2 repräsentiert. Dieser Rotorwinkel phi kann beispielsweise mittels eines Rotorwinkelsensors 2a messtechnisch erfasst werden oder als berechneter Wert von der Steuereinrichtung 20 bereitgestellt werden.

Ferner kann die Steuereinrichtung 20 auch einen Wert für den aktuellen Effektivstrom I_eff bereitstellen. Dieser Wert des aktuellen Effektivstroms I_eff kann beispielsweise aus einer dq-Transformation gewonnen werden.

In einem weiteren Schritt können der Realteil und der Imaginärteil der komplexen Stromsumme gefiltert werden. Hierbei können beispielsweise eine Tiefpassfilterung, eine kombinierte Tiefpass- und Bandpassfilterung oder eine Mittelwertbildung angewendet werden. Somit ergeben sich für die gefilterte komplexe Stromsumme ein Wert für den gefilterten Realteil zu I_Re_f, und ein Wert für den gefilterten Imaginärteil der komplexen Stromsumme zu I_Im_f.

Ferner wird auch der Effektivstrom I_eff mit der gleichen Filterzeitkonstante gefiltert, welche auch für die Filterung der komplexen Stromsumme genutzt wurde. Hierbei ergibt sich als gefilterter Effektivstrom der Wert I_eff_f.

Aus dem gefilterten Realteil und Imaginärteil der komplexen Stromsumme sowie dem gefilterten Effektivstrom kann somit ein komplexer Stromverstärkungsfehler wie folgt berechnet werden:

$$F\_err\_Re = I\_Re\_f / I\_eff\_f$$

$$F\_err\_Im = I\_Im\_f / I\_eff\_f$$

wobei F_err_Re den Realteil des komplexen Stromverstärkungsfehlers darstellt und F_err_Im den Imaginärteil des komplexen Stromverstärkungsfehlers darstellt.

Aus diesem komplexen Stromverstärkungsfehler kann daraufhin die Amplitude, das heißt der Betrag der komplexen Stromsumme wie folgt berechnet werden:

$$F\_err\_abs = sqrt(F\_err\_Re^2 + F\_err\_Im^2)$$

Der so berechnete Betrag bzw. die so berechnete Amplitude kann schließlich mit einem vorgegebenen Schwellwert verglichen werden. Liegt der berechnete Betrag bzw. die Amplitude unterhalb des vorgegebenen Schwellwerts, so liegen die Stromverstärkungsfaktoren der Stromsensoren 21 bis 23 innerhalb eines akzeptablen Toleranzbereiches. Überschreitet der Betrag jedoch den vorgegebenen Schwellwert, so ist dies ein Hinweis darauf, dass bei den Stromverstärkungsfaktoren der Stromsensoren 21 bis 23 eine Abweichung außerhalb eines noch zu akzeptierenden Toleranzbereiches auftritt. In einem solchen Fall können gegebenenfalls geeignete Maßnahmen ergriffen werden. Beispielsweise können die von den Stromsensoren 21 bis 23 bereitgestellten Sensorwerte nicht oder nur noch eingeschränkt weiter für die Regelung des elektrischen Antriebssystems berücksichtigt werden. Gegebenenfalls kann das elektrische Antriebssystem in einen Notbetrieb überführt werden oder auch vollständig heruntergefahren werden.

Neben den zuvor beschriebenen Abläufen ist es gegebenenfalls auch möglich, die Filteroperationen abweichend von dem zuvor beschriebenen Schema auszuführen. So können die Filteroperationen beispielsweise erst ausgeführt werden, nachdem der komplexe Verstärkungsfaktor berechnet worden ist. Ferner ist es auch je nach Anwendungsfall auch möglich Filteroperationen zu Zeitpunkten abweichend von dem oben beschriebenen Schema anzuwenden. Die Filteroperationen bzw. die Mittelwertbildung können entweder auf eine oder mehrere elektrische Perioden der Phasenströme angewendet wenden, um eine für den entsprechenden Anwendungsfall sinnvolle Filterung zu erzeugen.

Figur 2 zeigt eine schematische Darstellung eines Ablaufdiagramms, wie es einem Verfahren zur Überwachung von Stromsensoren in einem mehrphasigen elektrischen Antriebssystem zugrunde liegt. Das nachfolgend beschriebene Verfahren kann grundsätzlich beliebige Schritte umfassen, wie sie bereits zuvor in Zusammenhang mit der Diagnosevorrichtung 10 beschrieben worden sind.

Darüber hinaus kann auch die zuvor beschriebene Diagnosevorrichtung 10 selbstverständlich beliebige Komponenten aufweisen, um die nachfolgend beschriebenen Verfahrensschritte auszuführen.

In Schritt S1 erfolgt zunächst ein Erfassen von Sensorwerten von Stromsensoren für die Phasenströme einer elektrischen Maschine 2.

In Schritt S2 wird aus den erfassten Sensorwerten eine Stromsumme berechnet. In Schritt S3 erfolgt ein Bestimmen des Realteils und des Imaginärteils einer komplexen Stromsumme. Diese komplexe Stromsumme kann, wie zuvor bereits beschrieben, unter Verwendung des Rotorwinkels der elektrischen Maschine 2 in dem Antriebssystem erfolgen.

In Schritt S4 wird daraufhin ein komplexer Verstärkungsfaktor berechnet. Das Berechnen erfolgt dabei, wie zuvor bereits beschrieben, aus dem Quotienten des Realteils der komplexen Stromsumme und dem aktuellen effektiven Phasenstrom sowie dem Quotienten des Imaginärteils der komplexen Stromsumme und dem aktuellen effektiven Phasenstrom.

Schließlich erfolgt in Schritt S5 das Berechnen eines Betrags bzw. der Amplitude des komplexen Verstärkungsfaktors.

Der so berechnete Betrag des komplexen Verstärkungsfaktors kann mit einem vorgegebenen Schwellwert verglichen werden, um auf eine unzulässige Abweichung des Stromverstärkungsfaktors in einem der Stromsensoren 21 bis 23 zu schließen.

Zusammenfassend betrifft die vorliegende Erfindung die Diagnose von Stromsensoren in einem elektrischen Antriebssystem. Hierbei wird aus den von den Stromsensoren bereitgestellten Sensorwerten ein Summenstrom gebildet. Weicht dieser Summenstrom signifikant von Null ab, so kann unter Verwendung des Rotorwinkels der elektrischen Maschine eine komplexe Stromsumme berechnet werden. Diese komplexe Stromsumme wird auf den aktuellen Effektivstrom in dem elektrischen Antriebssystem bezogen, um auf Abweichungen in den Stromverstärkungsfaktoren der verwendeten Stromsensoren zu schließen.

## Patentansprüche

1. Verfahren zur Überwachung von Stromsensoren (21-23) für Phasenströme in einem mehrphasigen elektrischen Antriebssystem, mit den Schritten:

Erfassen (S1) von Sensorwerten für die Phasenströme, wobei jeweils ein Stromsensor (21-23) einen Phasenstrom des mehrphasigen elektrischen Antriebssystems ermittelt und einen zu dem ermittelten Phasenstrom korrespondierenden Sensorwert bereitstellt;

Berechnen (S2) einer Stromsumme unter Verwendung der erfassten Sensorwerte von den Stromsensoren (21-23);

**gekennzeichnet durch**

Bestimmen (S3) eines Realteils und eines Imaginärteils einer komplexen

Stromsumme unter Verwendung eines Rotorwinkels der elektrischen

Maschine (2) in dem elektrischen Antriebssystem;

Berechnen (S4) eines komplexen Verstärkungsfehlers aus einem Quotienten des Realteils der komplexen Stromsumme und einer aktuellen effektiven Phasenstrom-Amplitude sowie einem Quotienten des Imaginärteils der komplexen Stromsumme und der aktuellen effektiven Phasenstrom-Amplitude; und

Berechnen (S5) eines Betrags des komplexen Verstärkungsfehlers.

2.  Verfahren nach Anspruch 1, mit den Schritten:

Vergleichen des berechneten Betrags des komplexen Verstärkungsfehlers mit einem vorbestimmten Schwellwert; und

Detektieren eines Sensorfehlers, falls der berechnete Betrag des komplexen Verstärkungsfehlers den vorbestimmten Schwellwert überschreitet.

3.  Verfahren nach Anspruch 1 oder 2, mit einem Schritt zum Filtern der berechneten Stromsumme, wobei der Realteil und der Imaginärteil der komplexen Stromsumme unter Verwendung der gefilterten Stromsumme berechnet wird.

4.  Verfahren nach einem der Ansprüche 1 bis 3, mit den Schritten:

Filtern des Realteils und des Imaginärteils der komplexen Stromsumme,

Bestimmen eines effektiven Phasenstroms, und

Filtern eines zeitlichen Verlaufs des effektiven Phasenstroms,

wobei der Realteil und der Imaginärteil der komplexen Stromsumme sowie der zeitliche Verlauf des effektiven Phasenstroms mit einer gleichen Zeitkonstante gefiltert werden, und

wobei das Berechnen eines komplexen Verstärkungsfehlers unter Verwendung des gefilterten Realteils und des gefilterten Imaginärteils der komplexen Stromsumme sowie dem gefilterten effektiven Phasenstrom ausgeführt wird.

5.  Verfahren nach Anspruch 3 oder 4, wobei das Filtern der Stromsumme, des Realteils und des Imaginärteils der komplexen Stromsumme und/oder des zeitlichen Verlaufs des effektiven Phasenstroms eine Mittelwertbildung, eine Tiefpassfilterung oder eine kombinierte Tiefpassfilterung und Bandpassfilterung umfasst.

6.  Detektorvorrichtung (10) zur Überwachung von Stromsensoren für Phasenströme in einem mehrphasigen elektrischen Antriebssystem, mit:

einer Eingangsschnittstelle (11), die dazu ausgelegt ist, Sensorwerte für Phasenströme zu erfassen, wobei jeweils ein Stromsensor (21-23) einen Phasenstrom des mehrphasigen elektrischen Antriebssystems ermittelt und einen zu dem ermittelten Phasenstrom korrespondierenden Sensorwert bereitstellt;

einer Recheneinrichtung (12), die dazu ausgelegt ist, eine Stromsumme unter Verwendung der erfassten Sensorwerte von den Stromsensoren (21-23) zu berechnen, einen Realteil und einen Imaginärteil einer komplexen Stromsumme unter Verwendung eines Rotorwinkels der elektrischen Maschine (2) in dem elektrischen Antriebssystem zu bestimmen, einen komplexen Verstärkungsfehler aus einem Quotienten des Realteils der komplexen Stromsumme und einer aktuellen effektiven Phasenstrom-Amplitude sowie einem Quotienten des Imaginärteils der komplexen Stromsumme und der aktuellen effektiven Phasenstrom-Amplitude zu berechnen, und einen Betrag des komplexen Verstärkungsfehlers zu berechnen.

7.  Elektrisches Antriebssystem, mit

einer mehrphasigen elektrischen Maschine (2), mehreren Stromsensoren (21-23), die jeweils dazu ausgelegt sind, einen elektrischen Phasenstrom zu erfassen und einen zu dem erfassten Phasenstrom korrespondierenden Sensorwert auszugeben; und

eine Detektorvorrichtung (12) nach Anspruch 6.

## Claims

1.  Method for monitoring current sensors (21-23) for phase currents in a multi-phase electric drive system, having the steps of:

acquiring (S1) sensor values for the phase currents, wherein a respective current sensor (21-23) ascertains one phase current of the multi-phase electric drive system and provides a sensor value corresponding to the ascertained phase current;

calculating (S2) a total current by using the acquired sensor values from the current sensors (21-23); **characterized by**

determining (S3) a real part and an imaginary part of a complex total current by using a rotor angle of the electric machine (2) in the electric drive system;

calculating (S4) a complex gain error from a quotient of the real part of the complex total current and of a present effective phase current amplitude and a quotient of the imaginary part of the complex total current and of the present effective phase current amplitude; and

calculating (S5) an amount of the complex gain error.

2. Method according to Claim 1, having the steps of:

comparing the calculated amount of the complex gain error with a predetermined threshold value; and

detecting a sensor error if the calculated amount of the complex gain error exceeds the predetermined threshold value.

3. Method according to Claim 1 or 2, having a step for filtering the calculated total current, wherein the real part and the imaginary part of the complex total current are calculated using the filtered total current.

4. Method according to one of Claims 1 to 3, having the steps of:

filtering the real part and the imaginary part of the complex total current, determining an effective phase current, and filtering a time characteristic of the effective phase current,

wherein the real part and the imaginary part of the complex total current and the time characteristic of the effective phase current are filtered with an equal time constant, and

wherein the calculation of a complex gain error is performed using the filtered real part and the filtered imaginary part of the complex total current and the filtered effective phase current.

5. Method according to Claim 3 or 4, wherein the filtering of the total current, of the real part and of the imaginary part of the complex total current and/or of the time characteristic of the effective phase current comprises averaging, low-pass filtering or combined low-pass filtering and band-pass filtering.

6. Detector apparatus (10) for monitoring current sensors for phase currents in a multi-phase electric drive system, having:

an input interface (11) which is designed to acquire sensor values for phase currents, wherein a respective current sensor (21-23) ascertains one phase current of the multi-phase electric drive system and provides a sensor value corresponding to the ascertained phase current;

a computing device (12) which is designed to calculate a total current by using the acquired sensor values from the current sensors (21-23), to determine a real part and an imaginary part of a complex total current by using a rotor angle of the electric machine (2) in the electric drive system, to calculate a complex gain error from a quotient of the real part of the complex total current and of a present effective phase current amplitude and a quotient of the imaginary part of the complex total current and of the present effective phase current amplitude, and to calculate an amount of the complex gain error.

7. Electric drive system, having

a multi-phase electric machine (2), a plurality of current sensors (21-23), each designed to acquire an electric phase current and to output a sensor value corresponding to the acquired phase current; and a detector apparatus (12) according to Claim 6.

**Revendications**

1. Procédé de surveillance de capteurs de courant (21-23) pour des courants de phase dans un système d'entraînement électrique polyphasé, comprenant les étapes consistant à :

acquérir (S1) des valeurs de capteur pour les courants de phase, un capteur de courant (21-23) déterminant respectivement un courant de phase du système d'entraînement électrique polyphasé et fournissant une valeur de capteur correspondant au courant de phase déterminé ;

calculer (S2) un courant net en utilisant les valeurs de capteur acquises des capteurs de courant (21-23) ; **caractérisé par** le fait de

déterminer (S3) une partie réelle et une partie imaginaire d'un courant net complexe en utilisant un angle de rotor de la machine électrique (2) dans le système d'entraînement électrique ;

calculer (S4) une erreur d'amplification complexe à partir d'un quotient de la partie réelle du courant net complexe et d'une amplitude de courant de phase efficace actuelle ainsi que d'un quotient de la partie imaginaire du courant net complexe et de l'amplitude de courant de phase efficace actuelle ; et calculer (S5) un module de l'erreur d'amplification complexe.

2. Procédé selon la revendication 1, comprenant les étapes consistant à :

   comparer le module calculé de l'erreur d'amplification complexe à un seuil prédéterminé ; et détecter une erreur de capteur dans le cas où le module calculé de l'erreur d'amplification complexe dépasse le seuil prédéterminé.

3. Procédé selon la revendication 1 ou 2, comprenant une étape destinée à filtrer le courant net calculé, la partie réelle et la partie imaginaire du courant net complexe étant calculées en utilisant le courant net filtré.

4. Procédé selon l'une quelconque des revendications 1 à 3, comprenant les étapes consistant à :

   filtrer la partie réelle et la partie imaginaire du courant net complexe, déterminer un courant de phase efficace, et filtrer une évolution temporelle du courant de phase efficace, la partie réelle et la partie imaginaire du courant net complexe ainsi que l'évolution temporelle du courant de phase efficace étant filtrées avec une constante de temps identique, et le calcul d'une erreur d'amplification complexe étant effectué en utilisant la partie réelle filtrée et la partie imaginaire filtrée du courant net complexe ainsi que le courant de phase efficace filtré.

5. Procédé selon la revendication 3 ou 4, dans lequel le filtrage du courant net, de la partie réelle et de la partie imaginaire du courant net complexe et/ou de l'évolution temporelle du courant de phase efficace comprend un calcul de moyenne, un filtrage passe-bas ou un filtrage passe-bas et passe-bande combiné.

6. Dispositif détecteur (10) pour la surveillance de capteurs de courant pour des courants de phase dans un système d'entraînement électrique polyphasé, comprenant :

   une interface d'entrée (11), qui est conçue pour acquérir des valeurs de capteur pour les courants de phase, un capteur de courant (21-23) déterminant respectivement un courant de phase du système d'entraînement électrique polyphasé et fournissant une valeur de capteur correspondant au courant de phase déterminé ; un dispositif de calcul (12), qui est conçu pour calculer un courant net en utilisant les valeurs de capteur acquises des capteurs de courant (21-23), pour déterminer une partie réelle et une partie imaginaire d'un courant net complexe en utilisant un angle de rotor de la machine électrique (2) dans le système d'entraînement électrique, pour calculer une erreur d'amplification complexe à partir d'un quotient de la partie réelle du courant net complexe et d'une amplitude de courant de phase efficace actuelle ainsi que d'un quotient de la partie imaginaire du courant net complexe et de l'amplitude de courant de phase efficace actuelle, et pour calculer un module de l'erreur d'amplification complexe.

7. Système d'entraînement électrique, comprenant

   une machine électrique polyphasée (2), plusieurs capteurs de courant (21-23), qui sont respectivement conçus pour acquérir un courant de phase électrique et pour délivrer une valeur de capteur correspondant au courant de phase acquis ; et un dispositif détecteur (12) selon la revendication 6.

FIG. 1

FIG. 2

IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011003566 A1

- DE 102018251746 A1